# EUROPEAN PATENT SPECIFICATION

(11) **EP 2 037 497 B1**
(45) Date of publication and mention of the grant of the patent: **02.07.2014**
(21) Application number: 07744204.4
(22) Date of filing: 28.05.2007
(51) Int. Cl.: H01L 23/12, H01L 25/10, H01L 25/11, H01L 25/18, H01L 23/538

(54) **SEMICONDUCTOR PACKAGE AND ITS MANUFACTURING METHOD**
HALBLEITERKAPSELUNG UND HERSTELLUNGSVERFAHREN DAFÜR
PAQUET SEMI-CONDUCTEUR ET SON PROCEDE DE FABRICATION,

(30) Priority: 06.06.2006 JP 2006157137
(43) Date of publication of application: 18.03.2009
(73) Proprietor: NEC Corporation, Minato-ku Tokyo 108-8001 (JP)
(72) Inventor: MIKAMI, Nobuhiro, Tokyo 108-8001 (JP); WATANABE, Shinji, Tokyo 108-8001 (JP); SATO, Junya, Tokyo 108-8001 (JP); SAWADA, Atsumasa, Tokyo 108-8001 (JP)
(74) Representative: Stork Bamberger
(86) International application number: PCT/JP2007/060770
(87) International publication number: WO 2007/142052

(56) References cited:
- JP-A- 8 031 868
- JP-A- 8 213 424
- JP-A- 10 308 419
- JP-A- 2002 110 839
- JP-A- 2004 172 322
- JP-A- 2004 172 322
- US-A- 5 895 970
- US-A- 6 028 365
- US-A1- 2003 109 078
- US-A1- 2003 151 127
- US-A1- 2004 235 222
- US-A1- 2006 049 495
- US-A1- 2006 108 572

## Description

### TECHNICAL FIELD

(Related application) This application claims the benefit of Japanese Patent Application No. 2006-157137, filed June 6, 2006.

This invention relates to a semiconductor package on which a semiconductor chip has been mounted, a method of manufacturing the same, a semiconductor device and an electronic device. More particularly, the invention relates to a semiconductor package suited to an electronic device, the external appearance of which is curved, a method of manufacturing the same, a semiconductor device and an electronic device.

### BACKGROUND ART

Recent electronic devices tend to be lighter, thinner and smaller, and products in which emphasis is placed on design and that make frequent use of curved surfaces have begun to appear on the market. Further, products with a curved-surface design have been announced in the form of various electronic devices as concept models.

In order to realize lighter, thinner and smaller models the external appearance of which presents a curved surface, it is preferred that internal parts be mounted even on the curved portions, a goal which is not feasible with the packaging of the prior art. Preferably, a semiconductor device in which a semiconductor package is mounted on a substrate is curved to enable mounting in available space.

Prior-art examples of semiconductor devices in which a semiconductor package is mounted on a substrate will be described.

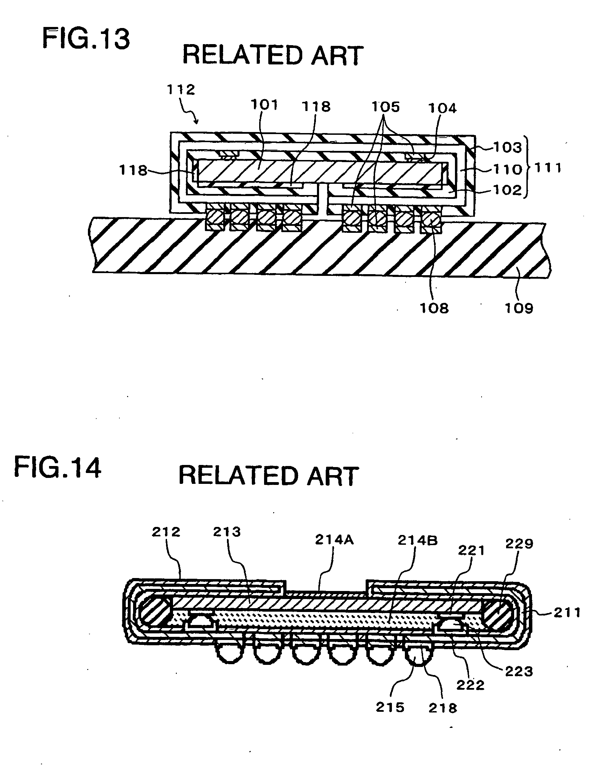

Fig. 13 is a sectional view schematically illustrating the structure of a semiconductor device in which a semiconductor package according to a first example of the prior art is mounted on a substrate. The first example of the prior art is a semiconductor device equipped with a chip-size package illustrated in Patent Document 1. With reference to Fig. 13, the semiconductor device according to the first example of the prior art includes a semiconductor chip 101 having a non-adhesive agent 118 applied to the entirety of the underside thereof with the exception of a very small area at the central portion, and to the side surfaces of the semiconductor chip 101. An interposer substrate 111 is formed so as to cover and entirely enclose the circumferential side surface of the semiconductor chip 101. The interposer substrate 111 is composed of a thermoplastic resin 102 disposed on the side facing the semiconductor chip 101, an insulating resin 103 comprising a thermoplastic resin or thermosetting resin disposed on the opposite side and a wiring pattern 110 adhered to and disposed between these two resin layers. The interposer substrate 111 is adhered to the semiconductor chip 101 by the thermoplastic resin 102 at the portion of the underside of the semiconductor chip 101 not coated with the non-adhesive 118. Conductors 104 are formed on respective electrode pads (not shown) formed on the semiconductor chip 101 by a wafer process. The semiconductor chip 101 is flip-chip connected to the wiring pattern 110 inside the interposer substrate via the conductors 104 and electrode pads 105 formed on the thermoplastic resin 102 adhered to the semiconductor chip 101. A plurality of the electrode pads 105 for external connection are formed on the insulating resin 103, which is formed on the outwardly facing side, on the portion formed on the underside of the semiconductor chip 101. Bumps 108 are formed on these external-connection electrode pads 105. These solder bumps 108 are flip-chip connected to respective ones of the electrode pads 105 formed on a substrate 109.

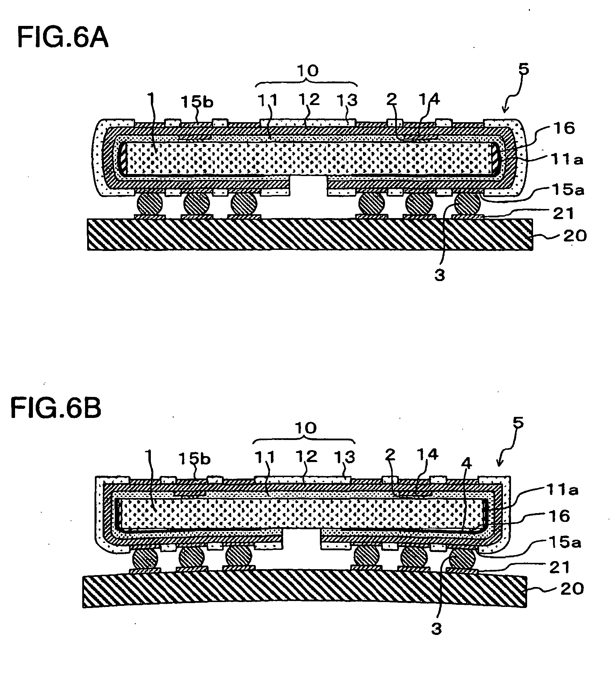

Fig. 14 is a sectional view schematically illustrating the structure of a semiconductor device according to a second example of the prior art. The second example of the prior art is a chip-size package illustrated in Patent Document 2. With reference to Fig. 14, the semiconductor device according to the second example of the prior art comprises: a bare chip 213 having a plurality of electrodes 221 provided on the circuit side thereof; a film-like member 212 covering the bare chip 213, provided on its inner side with a plurality of bare-chip mounting first electrodes 222 in correspondence with respective ones of the electrodes 221 of the bare chip 213 and provided on its outer side with a plurality of external-connection second electrodes 218 that are electrically continuous with the respective first electrodes 222; connecting means 223 for electrically connecting the electrodes 221 of the bare chip 213 with respective ones of the first electrodes 222 of the film-like member 212; and an insulating resin 214B, which fills the space between the inner surface of the film-like member 212 and the bare chip 213, for sealing the bare chip 213 and adhering the bare chip 213 to the film-like member 212. The film-like member 212 has a buffer 229 between the circumferential side surface of the bare chip 213 and the opposing inner surface.
[Patent Document 1]
   Japanese Patent Kokai Publication No. P2004-146751A (Paragraph 0093; Fig. 25)
[Patent Document 2]
   Japanese Patent Kokai Publication No. JP-A-8-335663 (paragraph 0031; Figs. 6A and 6B)

Document US 2003/0109078 A1 is directed to a semiconductor device having a package which has substantially the same size as that of a semiconductor chip which is suitable for a multiple-output semiconductor chip, as well as a method for manufacturing the same and a method for mounting the same.

Document US 2004/0235222 A1 relates to aggregating integrated circuits and to stacking integrated circuits in chip-scale package and providing such stacked integrated circuits on boards. According to the apparatus disclosed in document US 2004/0235222A1 it is essential to secure the wiring between two pads sandwiching the wiring layer 30, although spacing is provided on the side of the chip. One group of pads are disposed on the circuit side surface of the chip. The other opposing surface is fully adhered by the interposer substrate by means of adhesive.

Document US 6 028 365 A1 relates to an integrated circuit package, in which a flexible polymer tape or interconnect, having thin layers of metallic material forming conductors on one side, is secured to the die. The conductors are bonded to the bond pads of the die through openings in the flexible tape. The flexible tape or interconnect is folded back underneath the bottom of the die.

### DISCLOSURE OF THE INVENTION

### PROBLEMS TO BE SOLVED BY THE INVENTION

However, with the structures of the semiconductor packages described in Patent Documents 1 and 2, several problems arise in an effort to achieve curving after the package is mounted on a substrate.

The structures of the semiconductor packages described in these documents will be analyzed below from the standpoint of the present invention.

With regard to the semiconductor device of Patent Document 1 (see Fig. 13), when the substrate 109 repeatedly undergoes thermal expansion and cold shrinkage in accordance with a change in temperature, the interposer substrate 111 accommodates itself to this expansion/contraction movement of the substrate 109 via the solder bumps 108, and the occurrence of thermal stress ascribable to expansion/contraction movement of the substrate 109 can be prevented by the expansion and contraction of the interposer substrate 111 itself. However, the semiconductor chip 101 and interposer substrate 111 are adhered together or in contact over the entire circumference. When the substrate 109 is curved, therefore, a stress larger than the stress due to expansion/contraction movement of the substrate 109 is applied and, as a result, the semiconductor package cannot absorb this stress and cannot follow up curving. Consequently, when the substrate is curved, faulty connection due to cracking occurs in the semiconductor chip 101 and at the joints with the solder balls 108.

With regard to the semiconductor device of Patent Document 2 (see Fig. 14), bending stress that concentrates in the curved portion of the film-like member 212 can be mitigated by the buffer 229. However, since the bare chip 213 and film-like member 212 are adhered by the insulating resin 214B, when the semiconductor package is mounted on the substrate and the substrate is made to curve, faulty connection due to cracking occurs in the bare chip 213 and at the joints with the solder balls 215 and joint with the connecting means 223.

It is a primary object of the present invention to provide a highly reliable semiconductor package in which when a substrate is made curved, stress at the joints of solder bumps mounted on the substrate and in the semiconductor chip is mitigated to eliminate faulty connection, as well as a method of manufacturing this package, a semiconductor device and an electronic device.

### MEANS TO SOLVE THE PROBLEMS

In a first aspect of the present invention, a semiconductor package is characterized by the features according to claim 1.

In a second aspect not covered by the present invention, a three-dimensional semiconductor package obtained by stacking a plurality of semiconductor packages is characterized in that at least a semiconductor package among these semiconductor packages that is arranged lowermost and mounted directly on a substrate is the above-described semiconductor package (Mode 2).

In a third aspect not covered by the present invention, a semiconductor device is characterized in that the above-described semiconductor package or the above-described three-dimensional semiconductor package has been mounted on a substrate (Mode 3-1).

In a fourth aspect not covered by the present invention, an electronic device is characterized in that the above-described semiconductor device has been incorporated in a housing (Mode 4).

In a fifth aspect of the present invention, a method of manufacturing a semiconductor package according to claim 1 to 13 is provided.

The method comprises the features according to claim 14 (Mode 5).

### EFFECT OF THE INVENTION

In accordance with each of the aspects of the present invention, there is a gap between the interposer substrate and the side surface of the semiconductor chip and the interposer substrate has extra length. Even when the substrate on which the semiconductor package has been mounted is made to curve, therefore, the interposer substrate is capable of following up such bending, stress at the joints of solder bumps and in the semiconductor chip is relieved and a highly reliable semiconductor package devoid of faulty connections can be provided.

### BRIEF DESCRIPTION OF THE DRAWINGS

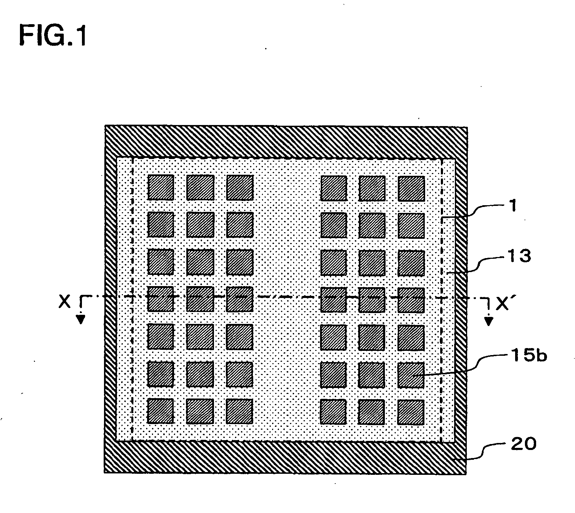

Fig. 1 is a plan view schematically illustrating the structure of a semiconductor device in which a semiconductor package according to a first exemplary embodiment of the present invention has been mounted on a substrate;

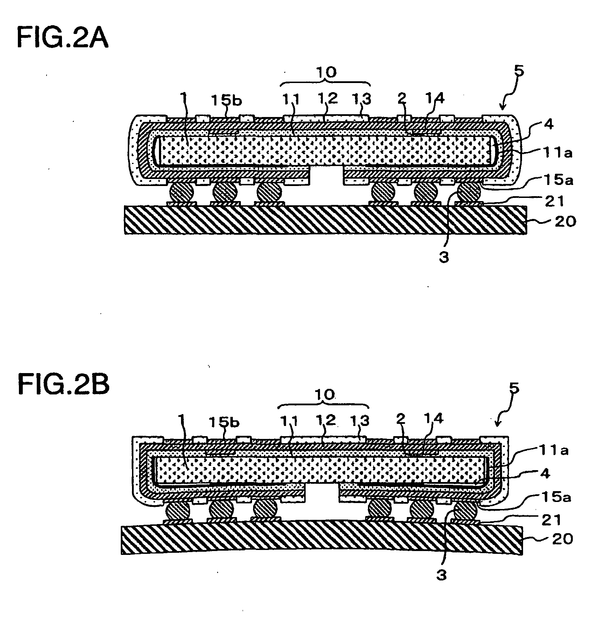

Figs. 2A and 2B are diagrams schematically illustrating the structure of a semiconductor device in which a semiconductor package according to a first exemplary embodiment of the present invention has been mounted on a substrate, in which Fig. 2A is a sectional view taken along line X-X' before bending and Fig. 2B a sectional view after bending;

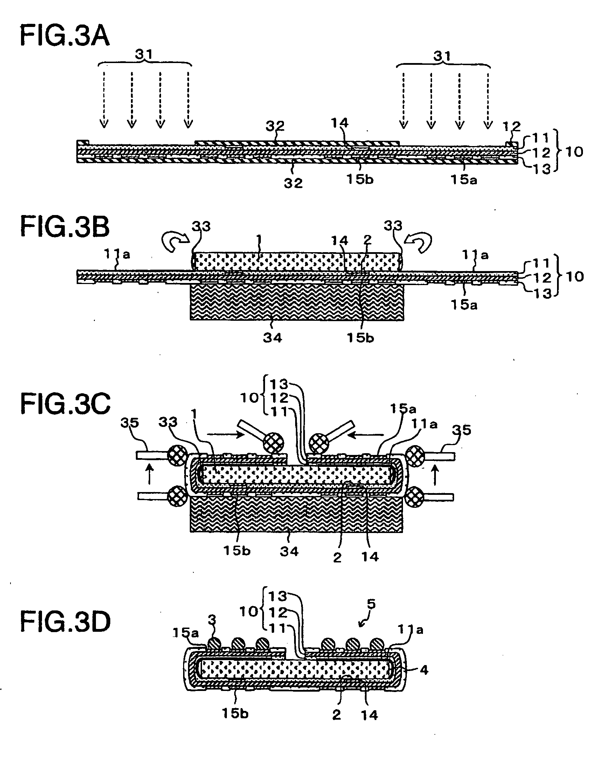

Figs. 3A to 3D are process sectional views schematically illustrating a method of manufacturing a semiconductor package according to a first exemplary embodiment of the present invention;

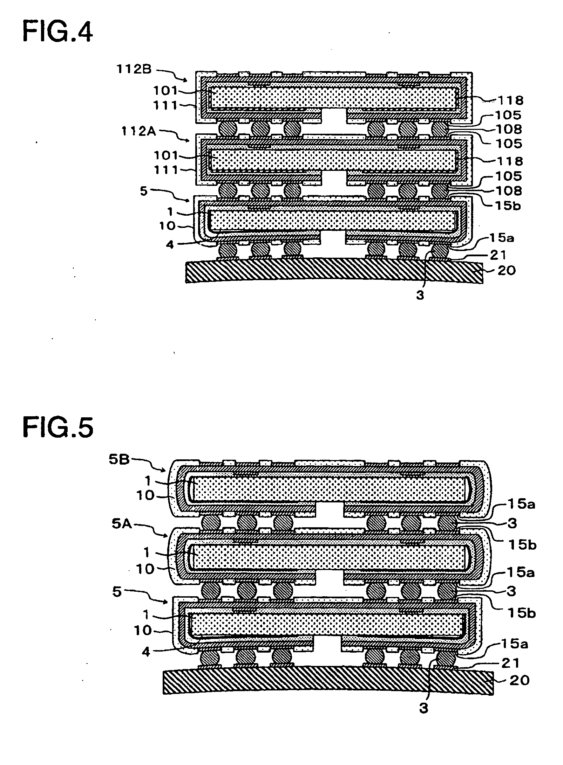

Fig. 4 is a sectional view schematically illustrating the structure (stacked type 1) of a semiconductor device in which a three-dimensional semiconductor package obtained by stacking other semiconductor packages on a semiconductor package according to a first exemplary embodiment of the present invention has been mounted on a curved substrate;
Fig. 5 is a sectional view schematically illustrating the structure (stacked type 2) of a semiconductor device in which a three-dimensional semiconductor package obtained by stacking other semiconductor packages on a semiconductor package according to a first exemplary embodiment of the present invention has been mounted on a curved substrate;
Figs. 6A and 6B are diagrams schematically illustrating the structure of a semiconductor device in which a semiconductor package according to a second exemplary embodiment of the present invention has been mounted on a substrate, in which Fig. 6A is a sectional view before bending and Fig. 6B a sectional view after bending;

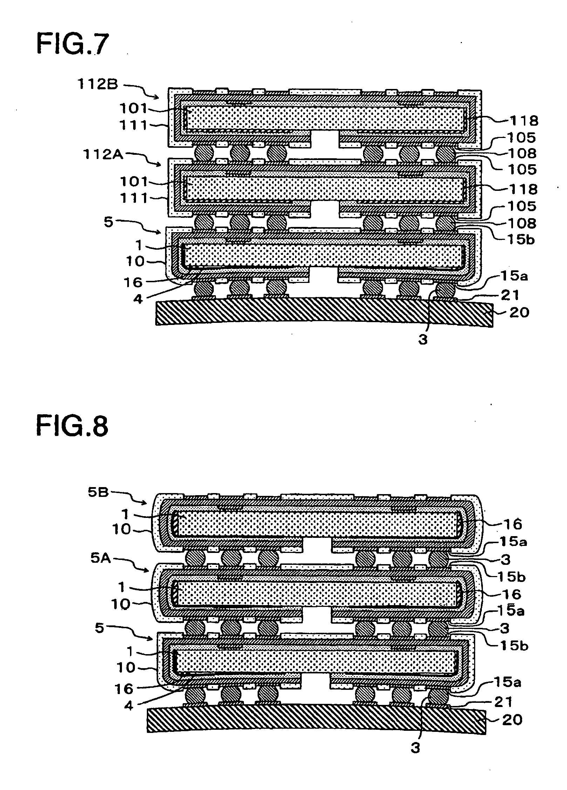

Fig. 7 is a sectional view schematically illustrating the structure (stacked type 1) of a semiconductor device in which a three-dimensional semiconductor package obtained by stacking other semiconductor packages on a semiconductor package according to a second exemplary embodiment of the present invention has been mounted on a curved substrate;
Fig. 8 is a sectional view schematically illustrating the structure (stacked type 2) of a semiconductor device in which a three-dimensional semiconductor package obtained by stacking other semiconductor packages on a semiconductor package according to a second exemplary embodiment of the present invention has been mounted on a curved substrate;

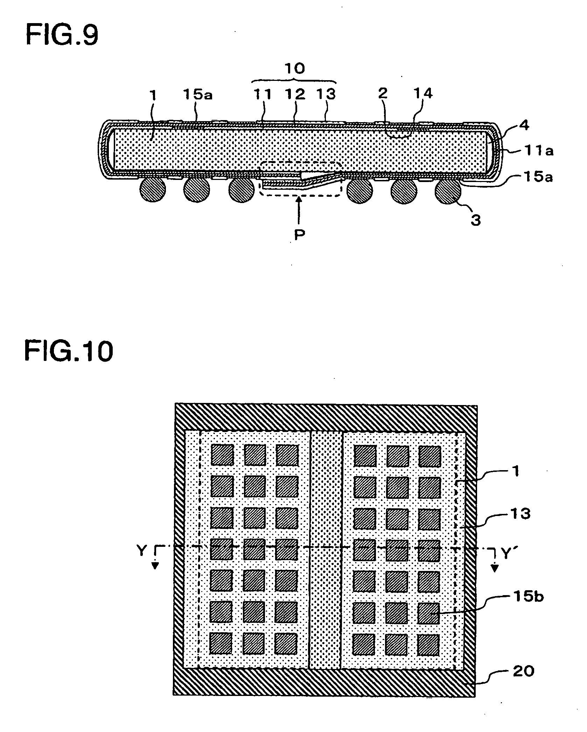

Fig. 9 is a sectional view schematically illustrating the structure of a semiconductor package according to a third exemplary embodiment of the present invention;
Fig. 10 is a plan view schematically illustrating the structure of a semiconductor device in which a semiconductor package according to a fourth exemplary embodiment of the present invention has been mounted on a substrate;

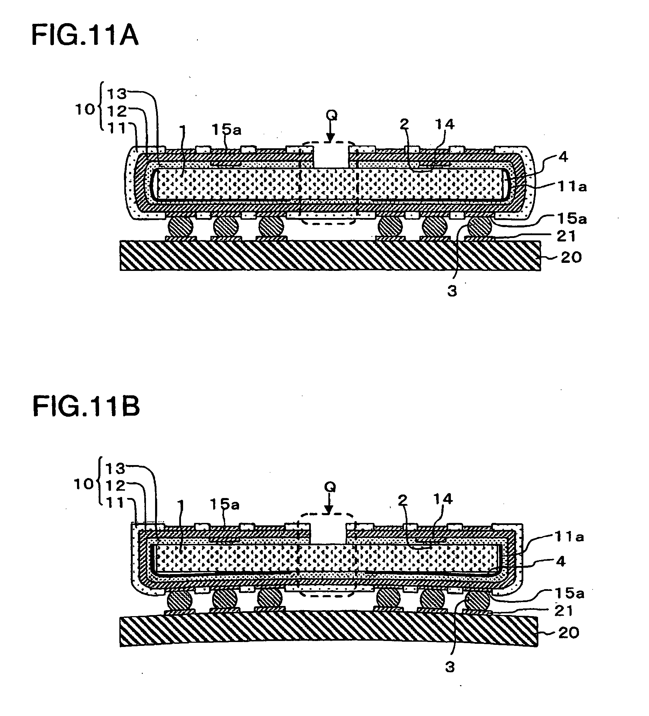

Figs. 11A and 11B are diagrams schematically illustrating the structure of a semiconductor device in which a semiconductor package according to a fourth exemplary embodiment of the present invention has been mounted on a substrate, in which Fig. 11A is a sectional view taken along line Y-Y' before bending and Fig. 11B a sectional view after bending;

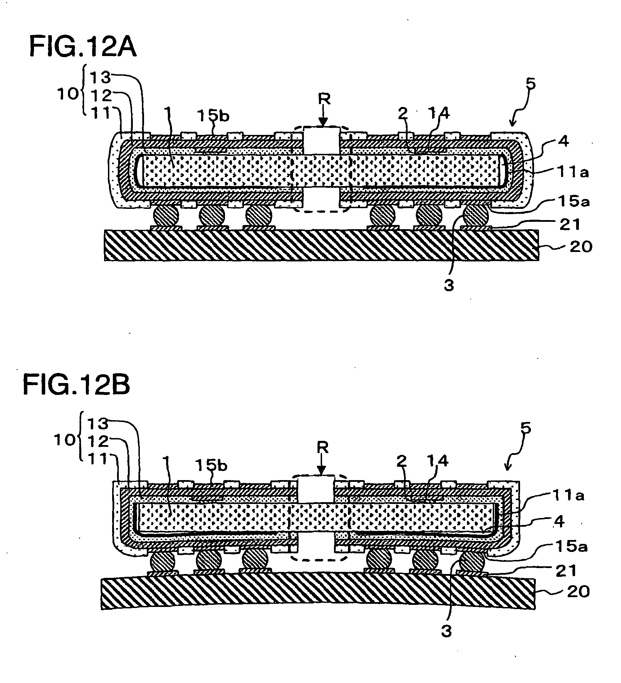

Figs. 12A and 12B are diagrams schematically illustrating the structure of a semiconductor device in which a semiconductor package according to a fifth exemplary embodiment of the present invention has been mounted on a substrate, in which Fig. 12A is a sectional view before bending and Fig. 12B a sectional view after bending;
Fig. 13 is a partial sectional view schematically illustrating the structure of a semiconductor device in which a semiconductor package according to a first example of the conventional art has been mounted; and
Fig. 14 is a sectional view schematically illustrating the structure of a semiconductor device according to a second example of the conventional art.

### EXPLANATIONS OF SYMBOLS

- 1: semiconductor chip
- 2: first conductor
- 3: second conductor
- 4: gap
- 5, 5A, 5B: semiconductor package
- 10: interposer substrate
- 11: thermoplastic resin (insulating layer)
- 11a: non-adhesion surface
- 12: wiring pattern (wiring layer)
- 13: insulating resin (insulating layer)
- 14, 15a, 15b: electrode pad
- 16: filling member
- 20: substrate
- 21: electrode pad
- 31: plasma
- 32: mask member
- 33: spacer
- 34: heater
- 35: roller
- 101: semiconductor chip
- 102: thermoplastic resin
- 103: insulating resin
- 104: conductor
- 105: electrode pad
- 108: solder bump
- 109: substrate
- 110: wiring pattern
- 111: interposer substrate
- 112, 112A, 112B: semiconductor package
- 118: non-adhesive material
- 211: conductor pattern
- 212: film-like member
- 213: bare chip
- 214A, 214B: insulating resin
- 215: solder ball
- 218: second electrode
- 221: electrode
- 222: first electrode
- 223: connecting means
- 229: buffer

### PREFERRED MODES FOR CARRYING OUT THE INVENTION

In a semiconductor package according to the present invention, an interposer substrate is, preferably, an interposer substrate having a first electrode pad, which is for connecting to an electrode of the semiconductor chip, provided on the surface of the semiconductor chip on the side thereof over the wiring layer, and a second electrode pad, which is for external connection, provided on the opposite surface side of the semiconductor chip (Mode 1-2).

In a semiconductor package according to the present invention, there can be provided a first conductor connecting an electrode on the semiconductor chip and the first electrode pad, and a second conductor provided on the second electrode pad (Mode 1-3).

It can be so arranged that when the interposer substrate is pushed from a direction of the side surface of the semiconductor chip, the gap moves at least toward the underside of the semiconductor chip and a state is attained in which the non-adhesion surface of the interposer substrate departs from the underside surface of the semiconductor chip (Mode 1-4).

The area of adhesion between the interposer substrate and semiconductor chip on the underside surface of the semiconductor chip can be made less than half the total area of the underside surface of the semiconductor chip (Mode 1-5).

The interposer substrate is capable of being adhesively secured to the underside surface of the semiconductor chip at a portion thereof in the vicinity of the center of the semiconductor chip (Mode 1-6).

Of the two insulating layers of the interposer substrate, the insulating layer situated on the side of the interposer substrate opposing the top side of the semiconductor chip can be formed of a thermoplastic resin (Mode 1-7).

A filling member formed of a pliable material can be provided in the gap between the semiconductor chip and the interposer substrate on the side surface of the semiconductor chip (Mode 1-8).

It can be so arranged that when the interposer substrate is pushed, or heated and pushed from the direction of the side surface of the semiconductor chip, the gap moves at least toward the underside of the semiconductor chip and a state is attained in which the non-adhesion surface of the interposer substrate departs from the underside of the semiconductor chip (Mode 1-9).

The filling member can be formed of a rubber material (Mode 1-10).

The filling member can be formed of a material that softens at a temperature at which solder melts or below (Mode 1-11).

The interposer substrate is such that its central portion is placed on the circuit side surface of the semiconductor chip and both end portions are folded onto the underside of the semiconductor chip and are spaced away from each other (Mode 1-12).

The interposer substrate is such that its central portion is placed on the circuit side surface of the semiconductor chip and both end portions are folded onto the underside of the semiconductor chip and overlap on the underside of the semiconductor chip (Mode 1-13). The interposer substrate is such that its central portion is placed on the underside surface of the semiconductor chip and both end portions are folded onto the circuit side of the semiconductor chip and are spaced away from each other on the circuit side of the semiconductor chip (Mode 1-14).

The interposer substrate is such that its central portion is placed on the side surface of the semiconductor chip, one end portion is folded onto the circuit side of the semiconductor chip and the other end portion is folded onto the underside of the semiconductor chip (Mode 1-15).

In a three-dimensional semiconductor package obtained by stacking a plurality of semiconductor packages, at least a semiconductor package among these semiconductor packages that is arranged lowermost and mounted directly on a substrate is the semiconductor package of any one of Modes 1-1 to 1-15 (Mode 2).

A semiconductor device can be obtained by mounting the semiconductor package of any one of Modes 1-1 to 1-15 or the three-dimensional semiconductor package of Mode 2 on a substrate (Mode 3-1).

The semiconductor package mounted directly on the substrate is such that when the substrate is made to curve, the gap moves at least toward the underside of the semiconductor chip and the interposer substrate attains a state in which the non-adhesion surface of the semiconductor chip departs from the underside surface of the semiconductor chip (Mode 3-2).

An electronic device can be obtained by incorporating the semiconductor device of Mode 3-1 or Mode 3-2 in a housing.

In a method of manufacturing a semiconductor package (Mode 5), the method can further comprise a step of extracting the members after the interposer substrate is bent onto the underside of the semiconductor chip (Mode 5-1).

### (First Exemplary Embodiment)

A semiconductor package according to a first exemplary embodiment of the present invention will be described with reference to the drawings. Fig. 1 is a plan view schematically illustrating the structure of a semiconductor device in which a semiconductor package according to a first exemplary embodiment of the present invention has been mounted on a substrate, and Figs. 2A and 2B are diagrams schematically illustrating the structure of a semiconductor device in which a semiconductor package according to a first exemplary embodiment of the present invention has been mounted on a substrate, in which Fig. 2A is a sectional view taken along line X-X' before bending and Fig. 2B a sectional view after bending

This semiconductor device has a semiconductor package 5 and a substrate 20. This semiconductor device is such that the semiconductor package 5 is mounted on the substrate 20 and is so adapted that even when the substrate 20 is made to curve, stress at the joint with a second conductor 3 and stress in the semiconductor chip 1 can be mitigated. The semiconductor device can be applied when it is incorporated in an electronic device using a housing having a curved surface. It goes without saying that even in a case where the housing has a planar shape, a separate part can be mounted in a space obtained between the device and the housing by curving the substrate 20. The semiconductor device is effective in a case where a part having a height greater than that of parts arranged in the vicinity is placed in a space comprising a large gap formed with the housing beneath the curved substrate.

The semiconductor package 5 is a chip-size package (CSP) in which the semiconductor chip 1 is packaged in a size approximately the same as that of the semiconductor chip 1. The semiconductor package 5 has the semiconductor chip 1, the first conductor 2, an interposer substrate 10 and the second conductor 3.

The semiconductor chip 1 is a chip having a semiconductor integrated circuit and includes a plurality of electrode pads (not shown) formed on the circuit side in a wafer process. The first conductor 2 is formed on each electrode pad (not shown) of the semiconductor chip 1. The semiconductor chip 1 is flip-chip connected to a wiring pattern 12 of the interposer substrate 10 via the first conductor 2 and a first electrode pad 14.

The first conductor 2 is a bump-shaped conductor that electrically connects (joins) each electrode pad (not shown) of the semiconductor chip 1 and the first electrode pad 14 of the interposer substrate 10. A conductor such as an Au, Sn-Ag, Sn-Cu, Sn-Ag-Cu, Sn-Bi, Sn-Zn solder can be used as the first conductor 2.

The second conductor 3 is a means for electrically connecting a second electrode pad 15a of the interposer substrate 10 and an externally connected part. A solder ball, for example, can be used as the second conductor.

The interposer substrate 10 is a flexible wiring board electrically connecting the semiconductor chip 1 and substrate 20. The interposer substrate 10 is formed so as to cover the two opposing sides of the semiconductor chip 1 in such a state that a fixed clearance (gap 4) exists between the interposer substrate and the side surface of the semiconductor chip 1. It should be noted that when the interposer substrate 10 is pushed from the direction of the side surface of the semiconductor chip 1, the gap 4 on the side surface of the semiconductor chip 1 moves at least toward the underside of the semiconductor chip 1 and a state is attained in which a non-adhesion surface 11a of the interposer substrate departs from the underside of the semiconductor chip 1. The interposer substrate 10 according to the first exemplary embodiment is such that the central portion of the substrate is placed on the circuit side of the semiconductor chip 1 and both end portions are folded onto the side (underside) of the semiconductor chip that is opposite the circuit side and are spaced away from each other. Extra length afforded by the gap 4 between the interposer substrate 10 and the side surface of the semiconductor chip 1 is made at such a length that when the substrate 20 is made to curve, the interposer substrate 10 will not be stretched even though it is pulled downward. This extra length is set in accordance with the bending modulus of the substrate 20; it is set to be large if the bending modulus of the substrate 20 is large and to be small if the bonding modulus of the substrate 20 is small. The interposer substrate 10 has a thermoplastic resin 11, wiring pattern 12; insulating resin 13, first electrode pad 14 and second electrode pads 15a, 15b.

The thermoplastic resin 11 is an insulating layer comprising a thermoplastic resin placed on the side of the interposer substrate 10 facing the semiconductor chip 1. The thermoplastic resin 11 has a hole for electrically connecting the electrode pad (not shown) of the semiconductor chip 1 and the wiring pattern 12. The first conductor 2 and first electrode pad 14 are placed in the hole. The thermoplastic resin 11 is adhered to the circuit side surface of the semiconductor chip 1 (with the exception of the surface on which the first electrode pad 14 is disposed) and to a portion in the vicinity of the center of the side (underside) of the semiconductor chip 1 that is opposite the circuit side surface (an area having a width that is half that of the central portion of the underside surface of semiconductor chip 1 that opposes the interposer substrate 10, particularly an area having a width perpendicular to the direction in which the resin extends up to the surface on the side of the semiconductor chip 1). The surface of the thermoplastic resin 11 opposing the side surface of the semiconductor chip 1 and the portion of the underside of semiconductor chip 1 with the exception of the adhesion surface is the non-adhesion surface 11a. It should be noted that if the electrode pad on the circuit side of the semiconductor chip 1 and the conductor are strongly connected at the surface where the first electrode pad 14 is disposed, then the thermoplastic resin 11 need not be adhered to the circuit side of the semiconductor chip 1 (with the exception of the surface where the first electrode pad 14 is disposed). The area of adhesion between the thermoplastic resin 11 and the semiconductor chip 1 at the portion in the vicinity of the center of the underside surface of semiconductor chip 1 preferably is made less than half the total area of the underside surface of semiconductor chip 1 so that when the interposer substrate 10 is pushed from the direction of the side surface of the semiconductor chip 1, the gap 4 will move at least toward the underside surface of the semiconductor chip 1 and a state will be attained in which the non-adhesion surface 11a of the interposer substrate departs from the underside surface of the semiconductor chip 1. The non-adhesion surface 11a of the thermoplastic resin 11 is such that there will be no adhesion to the semiconductor chip 1, even under heating, owing to surface improvement (e.g., plasma treatment or application of a non-viscous coating).

The wiring pattern 12 is a wiring layer comprising a conductor (e.g., copper) adhesively disposed between the thermoplastic resin 11 and insulating resin 13. The wiring pattern 12 is electrically connected to an electrode pad (not shown) of the semiconductor chip 1 via the first electrode pad 14 and first conductor 2 disposed in the hole of the thermoplastic resin 11. The wiring pattern 12 is electrically connected to the electrode pad 21 of the substrate 20 via the second electrode pad 15a and second conductor 3 disposed in a hole of the insulating resin 13. The wiring pattern 12 is electrically connected to the second electrode pad 15a disposed in the hole of the insulating resin 13.

The insulating resin 13 is an insulating layer comprising a thermoplastic resin or thermosetting resin disposed on the side of the interposer substrate 10 opposite the side facing the semiconductor chip 1. At the portion where it is folded onto the side of the laser unit 20, the insulating resin 13 has a hole for electrically connecting the electrode pad 21 of the substrate 20 and the wiring pattern 12. The second electrode pad 15a and second conductor 3 are disposed in this hole. In a case when another semiconductor package is stacked on the semiconductor package 5 (see Figs. 4 and 5), the portion of the insulating resin 13 folded onto the circuit side of the semiconductor chip 1 is formed to have a hole for electrically connecting a second conductor (not shown) of the other semiconductor package (not shown) and the wiring pattern 12, and a second electrode pad 15b is disposed in this hole. It should be noted that in a case when another semiconductor package is not stacked on the semiconductor package 5, the insulating resin 13 need not be provided with the hole for the second electrode pad 15b.

The first electrode pad 14 is an electrode pad comprising a conductive material (e.g., Ni/Au and Pd, etc.) for electrically connecting an electrode pad (not shown) of the semiconductor chip 1 and the wiring pattern 12. The first electrode pad 14 is placed in a hole provided in the thermoplastic resin 11 so as to penetrate to the wiring pattern 12 and opened at a position corresponding to an electrode pad (not shown) of the semiconductor chip 1.

The second electrode pad 15a is an electrode pad comprising a conductive material (e.g., Ni/Au and Pd, etc.) for electrically connecting the substrate 20 and the interposer substrate 10. The second electrode pad 15a is placed in a hole provided in the thermoplastic resin 13 so as to penetrate to the wiring pattern 12 and opened at a position corresponding to an electrode pad of the substrate 20. It should be noted that the second electrode pad 15b need not be provided in a case when another semiconductor package is not stacked on the semiconductor package 5.

The second conductor 3 is a conductor for electrically connecting the electrode pad 21 of the substrate 20 and the second electrode pad 15a of the interposer substrate 10. The substrate 20 is a substrate (wiring board) capable of being curved by heating. The substrate 20 has a wiring layer (not shown) provided as an inner layer in an insulating layer, and the electrode pad 21 connected to the wiring layer is exposed at the surface of the insulating layer on the side facing the semiconductor package 5. The electrode pad 21 is electrically connected to the second electrode pad 15a of the interposer substrate 10 via the second conductor 3.

A method of manufacturing the semiconductor package according to the first exemplary embodiment of the printed wiring board will be described next with reference to the drawings. Figs. 3A to 3D are process sectional views schematically illustrating a method of manufacturing a semiconductor package according to a first exemplary embodiment of the present invention.

First, the interposer substrate 10 having a wiring layer in which a pattern has been formed between two insulating layers is prepared. One of the insulating layers is the thermoplastic resin 11 and the one on the opposite side is the insulating resin 13.

Next, using a UV-YAG laser, a carbon dioxide gas laser or an excimer laser, etc., a plurality of holes that reach the wiring pattern 12 are formed at desired locations in the thermoplastic resin 11 and insulating resin 13 that constitute the interposer substrate 10 (step A1). Next, the electrode pads 14, 15a, 15b are formed by a well-known plating method and sputtering method, etc., at portions where the wiring pattern 12 is exposed in these holes (step A2).

Next, on the surface of the thermoplastic resin 11 of interposer substrate 10, a desired portion thereof to which the semiconductor chip 1 will be adhered is protected by being covered with a mask member 32 comprising a metal plate or the like, after which the thermoplastic resin 11 (the portion thereof that will not be adhered to the semiconductor chip 1) exposed from an opening in the mask member 32 is subjected to plasma 31, whereby the non-adhesion surface [lla in Fig. 3B] is formed [step A3; see Fig. 3A]. As a result, the adhesive strength of the non-adhesion surface [11a in Fig. 3B] of thermoplastic resin 11 vanishes.

Next, the first conductor 2 formed on the electrode pad (not shown) on the circuit side of semiconductor chip I is connected to the first electrode pad 14, which has been formed on the thermoplastic resin 11, by a well-known flip-chip technique such as thermal contact bonding using a flip-chip bonder, etc. (step A4).

Next, the interposer substrate 10, which has been connected to the semiconductor chip 1 via the first conductor 2 and first electrode pad 14, is placed in such a manner that the side of the insulating resin 13 to which the semiconductor chip 1 has not been connected is brought into contact with the top of a heater 34, and the semiconductor chip 1 is secured by vacuum adsorption [step A5; see Fig. 3B].

Next, spacers are disposed on both side surfaces of the semiconductor chip, the interposer substrate 10 is bent along the spacers 33, which have been placed on the side surfaces of the semiconductor chip 1, and along the underside of the semiconductor chip 1 while being heated on the heater 34, and a prescribed load (in the order of 0.5 to 3 kg) is applied from outside the interposer substrate 10 by rollers 35 made of a material exhibiting excellent resistance to heat such as silicon and Teflon (registered trademark), thereby adhering the circuit side and both end portions of the interposer substrate 10 to the top side of the semiconductor chip 1 [step A6; see Fig. 3C]. At this time the non-adhesion surface 11a of the thermoplastic resin 11 is not adhered to the top side of the semiconductor chip 1.

Next, the spacers 33 are extracted (step A7). Finally, the second conductor 3 is formed on the second electrode pad 15a of the interposer substrate 10 [step A8; see Fig. 3D]. As a result, the semiconductor package 5 can be obtained. The semiconductor package 5 thus obtained is mounted secondarily on a substrate.

In the manufacturing method described above, the spacers 33 are placed on both side surfaces of the semiconductor chip 1 in order to provide gaps 4. However, in a case where the overall length of the interposer substrate 10 for providing the gaps 4 is known, both end portions of the interposer substrate 10 that have been folded onto the underside of the semiconductor chip 1 are brought into contact with and adhered to the underside (e.g., at the center position) of the semiconductor chip 1 without being spaced apart. As a result, the prescribed load from the rollers 34 need only be applied to the top side of the semiconductor chip 1. Furthermore, an advantage is that the step of extracting the spacers can be eliminated. By adopting this method of manufacture, the semiconductor package having both end portions of the interposer substrate 10 in contact therewith can be obtained. In this case also it goes without saying that curving can be accommodated in a manner similar to a semiconductor package in which both end portions of the interposer substrate are spaced apart.

Next, a case when a semiconductor device in which the semiconductor package according to the first exemplary embodiment of the present invention has been mounted on a substrate is made to curve will be described.

When the flat substrate on which the semiconductor package 5 has been mounted [see Fig. 2A] is bent two-dimensionally into a convex shape (the shape of a circular cylinder) about the center of the semiconductor chip 1 in the transverse direction of Figs. 2A and 2B, the interposer substrate 10 adhered at the central portion of the underside of semiconductor chip 1 is deformed by following up the substrate 20 that curves, and the portion of the interposer substrate 10 on the side of the underside of semiconductor chip 1 curves into a convex (arcuate) shape, the center (point of contact) of which is the central portion of the underside of semiconductor chip 1 (namely the portion where the semiconductor chip 1 and thermoplastic resin 11 are adhered). As a result, the gap 4 between the side surface of the interposer substrate 10 and semiconductor chip 1 moves at least to the underside of the semiconductor chip 1 and a state is obtained in which the non-adhesion surface 11a of the interposer substrate 10 departs from the underside of the semiconductor chip 1. Since the interposer substrate 10 can thus follow up the curving of the substrate 20, stress does not develop at the joints of the second conductor 3 mounted on the substrate 20 and in the semiconductor chip 1.

Next, reference will be made to the drawings to describe a semiconductor device in which a three-dimensional semiconductor package obtained by stacking other semiconductor packages on the semiconductor package according to the first exemplary embodiment of the present invention is mounted on a curved substrate. Figs. 4 and 5 are sectional views schematically illustrating the structures of semiconductor devices in which a three-dimensional semiconductor package obtained by stacking other semiconductor packages on a semiconductor package according to the first exemplary embodiment of the present invention has been mounted on a curved substrate.

In Fig. 4, a three-dimensional semiconductor package obtained by stacking semiconductor packages 112A, 112B of the first example of the prior art on the semiconductor package 5 according to the first exemplary embodiment has been secondarily mounted on the curved substrate 20. The semiconductor package 5 mounted directly on the substrate 20 is placed at the lowermost level. The semiconductor packages 112A, 112B of the first example of the prior art are such that the semiconductor chip 101 and interposer substrate 111 are adhered together or in contact over their entire circumference (see Fig. 13). It should be noted that the semiconductor packages 112A, 112B may be adapted so as not to have the non-adhesive material 118. The second electrode pad 15a of the semiconductor package 5 is connected to the electrode pad 21 of substrate 20 via the second conductor 3. The semiconductor package 112A is connected to the second electrode pad 15b of semiconductor package 5 via the solder bump 108. The semiconductor package 112B is connected to the electrode pad 105 of semiconductor package 112A via the solder bump 108. Even in a case when curving is performed after this three-dimensional semiconductor package is mounted on the substrate 20, stress does not develop at the joints of the second conductor 3 mounted on the substrate 20 and in the semiconductor chip 1 in a manner similar to that when the above-described semiconductor package 5 alone is mounted on the substrate 20 and made to curve.

In Fig. 5, a three-dimensional semiconductor package obtained by stacking similar semiconductor packages 5A, 5B on the semiconductor package 5 according to the first exemplary embodiment has been secondarily mounted on the curved substrate 20. The semiconductor package 5 is connected to the electrode pad 21 of substrate 20 via the second conductor 3. The semiconductor package 5A is connected to the second electrode pad 15b of semiconductor package 5 via the second conductor 3. The semiconductor package 5B is connected to the second electrode pad 15b of semiconductor package 5A via the second conductor 3. Even in a case when curving is performed after this three-dimensional semiconductor package is mounted on the substrate 20, stress does not develop at the joints of the second conductor 3 mounted on the substrate 20 and in the semiconductor chip 1 in a manner similar to that when the above-described semiconductor package 5 alone is mounted on the substrate 20 and made to curve. Further, even in a case when stress in the semiconductor package 5 is transferred to the semiconductor packages 5A, 5B when the semiconductor package 5 is made to curve, stress does not develop at the joints of the second conductor 3 mounted on the substrate 20 and in the semiconductor chip 1 owing to effects similar to those exhibited by the semiconductor package 5.

In accordance with the first exemplary embodiment, the gap 4 is provided between the interposer substrate 10 and the side surface of the semiconductor chip 1 and the interposer substrate 10 has extra length. When the substrate 20 is made to curve, the interposer substrate 10 can follow up such curving. As a result, stress does not develop at the joints of the second conductor 3 and in the semiconductor chip 1. This makes it possible to provide a highly reliable semiconductor package free of faulty connections.

### (Second Exemplary Embodiment)

A semiconductor package according to a second exemplary embodiment of the present invention will be described with reference to the drawings. Figs. 6A and 6B are diagrams schematically illustrating the structure of a semiconductor device in which a semiconductor package according to a second exemplary embodiment of the present invention has been mounted on a substrate, in which Fig. 6A is a sectional view before bending and Fig. 6B a sectional view after bending.

In the semiconductor package according to the second exemplary embodiment, a filling member 16 is interposed in the gap (4 in Figs. 2A and 2B) between the semiconductor chip (1 in Figs. 2A and 2B) and interposer substrate (10 in Figs. 2A and 2B) of the semiconductor package according to the first exemplary embodiment. Other structural elements in the semiconductor package according to the second exemplary embodiment are similar to those of the semiconductor package according to the first exemplary embodiment.

The filling member 16 is formed of a pliable material, and examples that can be mentioned are materials exhibiting such properties as rubber resilience, viscous elasticity, creep, thermoplasticity, a gel property or a jelly property. Preferably, the filling member 16 is formed of a rubber material having a hardness of 30 or less. Further, a material that is hard at ordinary temperatures but that softens at a temperature not more than that at which the second conductor 3 melts can be used as the filling member 16. For example, a thermoplastic resin can be used. The filling member 16 is arranged between the side surface of the semiconductor chip 1 and the interposer substrate 10 before the substrate 20 is curved [see Fig. 6A]. When the semiconductor device is made to curve, this is carried out while applying heating in order to eliminate residual stress due to curving of the substrate 20. The temperature of the applied heat is not more than the temperature at which the first conductor 2 and second conductor 3 melt. When bending is performed two-dimensionally about the center of the semiconductor chip 1 in the transverse direction, the interposer substrate 10 is pulled downward via the second conductor 3 in a manner similar to that of the first exemplary embodiment. However, owing to application of heat at the time of bending, the filling member 16 is softened to such an extent that it can readily be deformed by the force by which the interposer substrate 10 is pulled downward. Owing to softening of the filling member 16, the softened portion of the filling member 16 moves to the vicinity of the corner on the underside of the semiconductor chip 1. This is similar to movement of the gap 4 between the interposer substrate 10 and the side surface of the semiconductor chip 1 to the underside of the semiconductor chip 1 in the first exemplary embodiment. However, the filling member 16 need not completely fill the clearance between the underside of semiconductor chip 1 and the interposer substrate 10 when the substrate 20 is made to curve, and may just as well have the gap 4.

Next, reference will be made to the drawings to describe a semiconductor device in which a three-dimensional semiconductor package obtained by stacking other semiconductor packages on the semiconductor package according to the second exemplary embodiment of the present invention is mounted on a curved substrate. Figs. 7 and 8 are sectional views schematically illustrating the structures of semiconductor devices in which a three-dimensional semiconductor package obtained by stacking other semiconductor packages on a semiconductor package according to the second exemplary embodiment of the present invention has been mounted on a curved substrate.

In Fig. 7, a three-dimensional semiconductor package obtained by stacking semiconductor packages 112A, 112B of the first example on the semiconductor package 5 according to the first exemplary embodiment has been secondarily mounted on the curved substrate 20. The semiconductor packages 112A, 112B of the first example of the prior art are such that the semiconductor chip 101 and interposer substrate 111 are adhered together or in contact over their entire circumference (see Fig. 13). It should be noted that the semiconductor packages 112A, 112B may be arranged so as not to have the non-adhesive material 118. The semiconductor package 5 is connected to the electrode pad 21 of the substrate 20 via the second conductor 3. The semiconductor package 112A is connected to the second electrode pad 15b of semiconductor package 5 via the solder bump 108. The semiconductor package 112B is connected to the electrode pad 105 of semiconductor package 112A via the solder bump 108. Even in a case when curving is performed after this three-dimensional semiconductor package is mounted on the substrate 20, stress does not develop at the joints of the second conductor 3 mounted on the substrate 20 and in the semiconductor chip 1 in a manner similar to that of the first exemplary embodiment.

In Fig. 8, a three-dimensional semiconductor package obtained by stacking similar semiconductor packages 5A, 5B on the semiconductor package 5 according to the second exemplary embodiment has been secondarily mounted on the curved substrate 20. It should be noted that the semiconductor packages 5A, 5B may be adapted so as not to have the filling member 16. The semiconductor package 5 is connected to the electrode pad 21 of substrate 20 via the second conductor 3. The semiconductor package 5A is connected to the second electrode pad 15b of semiconductor package 5 via the second conductor 3. The semiconductor package 5B is connected to the second electrode pad 15b of semiconductor package 5A via the second conductor 3. Even in a case when curving is performed after this three-dimensional semiconductor package is mounted on the substrate 20, stress does not develop at the joints of the second conductor 3 mounted on the substrate 20 and in the semiconductor chip 1 in a manner similar to that of the first exemplary embodiment. Further, even in a case when stress in the semiconductor package 5 is transferred to the semiconductor packages 5A, 5B when the semiconductor package 5 is made to curve, stress does not develop at the joints of the second conductor 3 mounted on the substrate 20 and in the semiconductor chip 1 owing to effects similar to those exhibited by the semiconductor package 5.

In accordance with the second exemplary embodiment, effects similar to those of the first exemplary embodiment are obtained. If the filling member 16 is used instead of the spacers [33 in Fig. 3B] employed in the method of manufacturing the semiconductor package according to the first exemplary embodiment, an advantage obtained is that the step of extracting the spacers [33 in Fig. 3B] can be eliminated. In comparison with the semiconductor package having the gaps 4 at both side surfaces of the semiconductor chip 1, an advantage is greater stability afforded by filling the gaps with the filling members 16. With regard to the placement of the filling member 16, it is not necessarily required that the entirety of the space between the side surface of the semiconductor chip 1 and the interposer 10 be filled. By partially filling the space, such as by placing the filling member at points along the side surface of the semiconductor chip, it is possible to improve the follow-up ability of the interposer substrate 10 when curving is performed.

### (Third Exemplary Embodiment)

A semiconductor package according to a third exemplary embodiment of the present invention will be described with reference to the drawings. Fig. 9 is a sectional view schematically illustrating the structure of a semiconductor package according to a third exemplary embodiment of the present invention.

In the semiconductor package (5 in Figs. 2A, 2B, 6A and 6B) according to the first and second exemplary embodiments, the arrangement is such that the end portions of the interposer substrate (10 in Figs. 2A, 2B, 6A and 6B) are folded onto the side (the underside) of the semiconductor chip 1 that is opposite the circuit side, and the two end portions are spaced away from each other. In the semiconductor package 5 according to the third exemplary embodiment, however, the arrangement is such that both end portions of the interposer substrate 10 overlap each other (see are a P enclosed by the dashed line in Fig. 9). Other structural elements in the semiconductor package 5 according to the third exemplary embodiment are similar to those of the first and second exemplary embodiments.

With regard to the interposer substrate 10, the thermoplastic resin 11 is adhered to the circuit side of the semiconductor chip 1 and to the portion in the vicinity of the center of the surface (the underside surface) of the semiconductor chip 1 that is on the side opposite the circuit side surface. The left-side (in Fig. 9) end portion that has been folded onto the underside of the semiconductor chip 1 is adhered to the underside of the semiconductor chip 1 at the portion in the vicinity of the center thereof, and the right-side end portion that has been folded onto the underside surface of the semiconductor chip 1 is adhered to the insulating resin 13 of the left-hand end portion at all or part of an overlap area. Further, the surface of the thermoplastic resin 11 opposing the side surface of the semiconductor chip 1 and the portion of the underside of semiconductor chip 1 with the exception of the adhesion surface is the non-adhesion surface 11a. The area of adhesion between the thermoplastic resin 11 and the semiconductor chip 1 at the portion in the vicinity of the center of the underside of semiconductor chip 1 preferably is made not more than half the total area of the underside surface of semiconductor chip 1. Further, the area of adhesion between the thermoplastic resin 11 and insulating resin 13 in the are a where both end portions of the interposer substrate 10 overlap preferably is made not more than half the total area of the underside surface of semiconductor chip 1.

It should be noted that the clearance between the side surface of the semiconductor chip 1 and the interposer substrate 10 in Fig. 9 is the gap 4. However, the filling member (see 16 in Figs. 6A and 6B) illustrated in the second exemplary embodiment may be interposed in the clearance.

Further, in a case when the semiconductor package 5 is mounted on a substrate and the substrate is made to curve, the gap 4 or filling member between the side surface of the semiconductor chip 1 and the interposer substrate 10 moves at least to the underside of the semiconductor chip 1 so that a state is attained in which the non-adhesion surface 11a of the interposer substrate 10 departs from the underside of the semiconductor chip 1 in a manner similar to that of the first and second exemplary embodiments.

Further, the arrangement in which both end portions of the interposer substrate 10 of the third exemplary embodiment overlap can also be applied to each of the semiconductor packages in the three-dimensional semiconductor packages of the first and second exemplary embodiments (see 5, 112A, 112B in Fig. 4; 5, 5A, 5B in Fig.5; 5, 112A, 112B in Fig. 7; and 5, 5A, 5B in Fig. 8).

In accordance with the third exemplary embodiment, even in a case when curving is performed after the semiconductor package 5 is secondarily mounted on the substrate, stress does not develop at the joints of the second conductor 3 mounted on the substrate and in the semiconductor chip 1 owing to effects similar to those of the first and second exemplary embodiments. This makes it possible to provide a highly reliable semiconductor package structure free of faulty connections. Further, the arrangement is such that both end portions of the interposer substrate 10 overlap each other. In comparison with the first and second exemplary embodiments, therefore, the area of adhesion between both end portions of the interposer substrate 10 folded onto the underside of the semiconductor chip 1 is enlarged. This is advantageous in that reliability can be enhanced.

### (Fourth Exemplary Embodiment)

A semiconductor package according to a fourth exemplary embodiment of the present invention will be described with reference to the drawings. Fig. 10 is a plan view schematically illustrating the structure of a semiconductor device in which a semiconductor package according to a fourth exemplary embodiment of the present invention has been mounted on a substrate. Figs. 11A and 11B are diagrams schematically illustrating the structure of a semiconductor device in which a semiconductor package according to a fourth exemplary embodiment of the present invention has been mounted on a substrate, in which Fig. 11A is a sectional view taken along line Y-Y' before bending and Fig. 11B a sectional view after bending.

In the semiconductor package (5 in Figs. 2A, 2B, 6A and 6B) according to the first and second exemplary embodiments, the arrangement is such that the central portion of the interposer substrate (10 in Figs. 2A, 2B, 6A and 6B) is placed on the circuit side of the semiconductor chip 1, the end portions of the interposer substrate are folded onto the surface (the underside surface) of the semiconductor chip 1 that is on the side opposite the circuit side surface, and the two end portions are spaced away from each other. In the semiconductor package 5 according to the fourth exemplary embodiment, however, the arrangement is such that the central portion of the interposer substrate (10 in Figs. 2A, 2B, 6A and 6B) is placed on the underside surface of the semiconductor chip 1, the end portions of the interposer substrate are folded onto the circuit side of the semiconductor chip 1 and the two end portions are spaced away from each other (see area Q enclosed by the dashed line in Figs. 11A and 11B). Other structural elements in the semiconductor package 5 according to the fourth exemplary embodiment are similar to those of the first and second exemplary embodiments.

With regard to the interposer substrate 10, the thermoplastic resin 11 is adhered to the circuit side surface of the semiconductor chip 1 and to the portion in the vicinity of the center of the side (the underside) of the semiconductor chip 1 that is opposite the circuit side. Further, the surface of the thermoplastic resin 11 opposing the side surface of the semiconductor chip 1 and the portion of the underside of semiconductor chip 1 with the exception of the portion in the vicinity of the center (the adhesion surface) is the non-adhesion surface 11a. The area of adhesion between the thermoplastic resin 11 and the semiconductor chip 1 at the portion in the vicinity of the center of the underside of semiconductor chip 1 preferably is made not more than half the total area of the underside surface of semiconductor chip 1.

It should be noted that the clearance between the side surface of the semiconductor chip 1 and the interposer substrate 10 in Fig. 11A is the gap 4. However, the filling member (see 16 in Figs. 6A and 6B) illustrated in the second exemplary embodiment may be interposed in the clearance.

Further, in a case when the semiconductor package 5 is mounted on the substrate 20 and the substrate 20 is made to curve, the gap 4 or filling member between the side surface of the semiconductor chip 1 and the interposer substrate 10 moves at least to the underside of the semiconductor chip 1 so that a state is attained in which the non-adhesion surface 11a of the interposer substrate 10 departs from the underside surface of the semiconductor chip 1 in a manner similar to that of the first and second exemplary embodiments [see Fig. 11B].

Further, the arrangement in which the end portions of the interposer substrate 10 of the fourth exemplary embodiment are folded onto circuit side of the semiconductor chip 1 can also be applied to each of the semiconductor packages in the three-dimensional semiconductor packages of the first and second exemplary embodiments (see 5, 112A, 112B in Fig. 4; 5, 5A, 5B in Fig. 5; 5, 112A, 112B in Fig. 7; and 5, 5A, 5B in Fig. 8).

In accordance with the fourth exemplary embodiment, even in a case when curving is performed after the semiconductor package 5 is secondarily mounted on the substrate 20, stress does not develop at the joints of the second conductor 3 mounted on the substrate 20 and in the semiconductor chip 1 owing to effects similar to those of the first and second exemplary embodiments. This makes it possible to provide a highly reliable semiconductor package structure free of faulty connections.

### (Fifth Exemplary Embodiment)

A semiconductor package according to a fifth exemplary embodiment of the present invention will be described with reference to the drawings. Figs. 12A and 12B are diagrams schematically illustrating the structure of a semiconductor device in which a semiconductor package according to a fifth exemplary embodiment of the present invention has been mounted on a substrate, in which Fig. 12A is a sectional view before bending and Fig. 12B a sectional view after bending.

In the semiconductor packages (5 in Figs. 2A, 2B, 6A and 6B) according to the first and second exemplary embodiments, the arrangement is such that a single interposer substrate (10 in Figs. 2A, 2B, 6A and 6B) is used. In the semiconductor package 5 according to the fifth exemplary embodiment, however, the arrangement is such that a plurality (two in Figs. 12A and 12B) of interposer substrates 10 are used. Other structural elements in the semiconductor package 5 according to the fourth exemplary embodiment are similar to those of the first and second exemplary embodiments.

With regard to the interposer substrates 10, the central portions of the substrates are placed on the side surface of the semiconductor chip 1 and the end portions are folded onto the circuit side and underside of the semiconductor chip 1. The two interposer substrates 10 are arranged on the circumference of the semiconductor chip 1 with left-right symmetry. However, the wiring patterns of the two interposer substrates 10 need not necessarily be the same. The end portions of the two interposer substrates 10 are spaced away from each other (see area R enclosed by the dashed line in Fig. 12A and 12B). The thermoplastic resin 11 in each interposer substrate 10 is adhered to the circuit side surface of the semiconductor chip 1 and to the portion in the vicinity of the center of the surface (underside surface) of the semiconductor chip 1 that is opposite the circuit side. The entirety of the portion folded onto the circuit side surface of the semiconductor chip 1 is adhered to the circuit side of the semiconductor chip 1. Further, the surface of the thermoplastic resin 11 opposing the side surface of the semiconductor chip 1 and the portion of the underside of semiconductor chip I with the exception of the portion in the vicinity of the center (the adhesion surface) is the non-adhesion surface 11a. The area of adhesion between the thermoplastic resin 11 and the semiconductor chip 1 at the portion in the vicinity of the center of the underside surface of semiconductor chip 1 preferably is made not more than half the total area of the underside surface of semiconductor chip 1.

It should be noted that the clearance between the side surface of the semiconductor chip 1 and the interposer substrate 10 in Fig. 12A is the gap 4. However, the filling member (see 16 in Figs. 6A and 6B) illustrated in the second exemplary embodiment may be interposed in the clearance.

Further, in a case where the semiconductor package 5 is mounted on the substrate 20 and the substrate 20 is made to curve, the gap 4 or filling member between the side surface of the semiconductor chip 1 and the interposer substrate 10 moves at least to the underside of the semiconductor chip 1 so that a state is attained in which the non-adhesion surface 11a of the interposer substrate 10 departs from the underside surface of the semiconductor chip 1 in a manner similar to that of the first and second exemplary embodiments [see Fig. 12B].

Further, the arrangement using the plurality of interposer substrates 10 of the fifth exemplary embodiment can also be applied to each of the semiconductor packages in the three-dimensional semiconductor packages of the first and second exemplary embodiments (see 5, 112A, 112B in Fig. 4; 5, 5A, 5B in Fig. 5; 5, 112A, 112B in Fig. 7; and 5, 5A, 5B in Fig. 8).

In accordance with the fifth exemplary embodiment, even in a case when curving is performed after the semiconductor package 5 is secondarily mounted on the substrate 20, stress does not develop at the joints of the second conductor 3 mounted on the substrate 20 and in the semiconductor chip 1 owing to effects similar to those of the first and second exemplary embodiments. This makes it possible to provide a highly reliable semiconductor package structure free of faulty connections.

Further, in accordance with the fifth exemplary embodiment, the top and bottom surfaces of the semiconductor chip 1 are partially covered with the interposer substrates 10. This is effective in terms of heat dissipation. This is particularly effective in semiconductor chips for power amplifiers and CPUs, which exhibit high heat build-up.

It should be noted that with regard to the three-dimensional semiconductor packages of each of the exemplary embodiments, the lowermost semiconductor package mounted on a substrate is the semiconductor package of the present invention. However, the semiconductor package mounted thereon may be the semiconductor package of the present invention or the semiconductor packages according to the first and second examples of the conventional art.

Further, the invention has been described assuming that the substrate is a rigid substrate. However, as long as the substrate is one that is curved after the semiconductor package is mounted thereon, it may be a flexible substrate, in which case it is unnecessary to curve the substrate by heating it. For example, by mounting the semiconductor device of the present invention in a housing having a curved shape, the interposer substrate and gap provided in the semiconductor package follow up and are deformed (move) in accordance with the curved shape of the housing, and stress that acts upon the conductors such as solder bumps can be mitigated and absorbed. In a case when the filling member is disposed in the gap, a material capable of being deformed without application of heat can be selected as the filling member, thereby making it possible to eliminate a heating step.

## Claims

1. A semiconductor package (5, 5A, 5B; 112A, 112B) **characterized by** comprising:
a semiconductor chip (1) having a plurality of electrodes formed on a circuit side surface thereof; and
an interposer substrate (10) arranged so as to enclose a portion of the circuit side of said semiconductor chip (1), a portion of at least one side surface thereof and a portion of the underside surface thereof opposing to said circuit side surface, and having a wiring layer (12) between two insulating layers (11,13);
a prescribed gap (4) is provided at the side surface of said semiconductor chip (1) by spacing said semiconductor chip (1) away from said interposer substrate (10); and
said underside surface of said semiconductor chip has a portion adhered to said interposer substrate (10), and a portion not adhered to said interposer substrate (10), in a portion opposing to said circuit side, said adhered portion being adhered to one of said insulating layers (11, 13) by way of the insulating layer (11, 13) itself.

2. A semiconductor package (5, 5A, 5B; 112A, 112B) according to claim 1, **characterized in that** said interposer substrate (10) has a first electrode pad (14), which is for connecting to an electrode of said semiconductor chip (1), provided on the surface of said semiconductor chip (1) on the side thereof over said wiring layer (12), and a second electrode pad (15a, 15b), which is for external connection, provided on the opposite surface side of said semiconductor chip (1) opposite to a surface for the wiring layer (12).

3. A semiconductor package (5, 5A, 5B; 112A, 112B) according to claim 1 or 2, **characterized by** further comprising:
a first conductor (2) connecting an electrode on said semiconductor chip (1) and said first electrode pad (14); and
a second conductor (3) provided on said second electrode pad (15a; 15b).

4. A semiconductor package (5, 5A, 5B; 112A, 112B) according to any one of claims 1 to 3, **characterized in that** when said interposer substrate (10) is pushed, or heated and pushed from a direction of the side surface of said semiconductor chip (1), the gap (4) moves at least toward the underside of said semiconductor chip (1) and a state is attained in which a non-adhesion surface (11a) of said interposer substrate (10) departs from the underside of said semiconductor chip (1).

5. A semiconductor package (5, 5A, 5B; 112A, 112B) according to any one of claims 1 to 4, **characterized in that** area of adhesion between said interposer substrate (10) and said semiconductor chip (1) on the underside surface of said semiconductor chip (1) is less than half the total area of the underside surface of said semiconductor chip (1).

6. A semiconductor package (5, 5A, 5B; 112A, 112B) according to any one of claims 1 to 5, **characterized in that** said interposer substrate (10) is adhesively secured to the underside surface of said semiconductor chip (1) at a portion thereof in the vicinity of the center of said semiconductor chip (1).

7. A semiconductor package (5, 5A, 5B; 112A, 112B) according to any one of claims 1 to 6, **characterized in that** of the two insulating layers (11, 13) of said interposer substrate (10), the insulating layer situated (11) on the side of the interposer substrate (10) opposing the top side of said semiconductor chip (1) comprises a thermoplastic resin.

8. A semiconductor package (5, 5A, 5B; 112A, 112B) according to any one of claims 1 to 7, **characterized by** further comprising a filling member (16) formed of a pliable material provided in said gap (4) between said semiconductor chip (1) and said interposer substrate (10) on the side surface of said semiconductor chip (1).

9. A semiconductor package (5, 5A, 5B; 112A, 112B) according to any one of claims 4 to 8, **characterized in that** said filling member (16) is formed of a rubber material.

10. A semiconductor package (5, 5A, 5B; 112A, 112B) according to any one of claims 4 to 9, **characterized in that** said filling member (16) is formed of a material that softens at a temperature at which solder melts or below.

11. A semiconductor package (5, 5A, 5B; 112A, 112B) according to any one of claims 1 to 10, **characterized in that** said interposer substrate (10) has its central portion placed on the circuit side surface of said semiconductor chip (1) and both end portions thereof folded onto the underside of said semiconductor chip (1) and spaced away from each other.

12. A semiconductor package (5, 5A, 5B; 112A, 112B) according to any one of claims 1 to 10, **characterized in that** said interposer substrate (10) has its central portion placed on the circuit side surface of said semiconductor chip (1) and both end portions thereof folded onto the underside of said semiconductor chip (1) and overlapped.

13. A semiconductor package (5, 5A, 5B; 112A, 112B) according to any one of claims 1 to 10, **characterized in that** said interposer substrate (10) has its central portion placed on the underside surface of said semiconductor chip (1) and both end portions thereof folded onto the circuit side of said semiconductor chip (1) and spaced away from each other on the circuit side of said semiconductor chip (1).

14. A method of manufacturing a semiconductor package according to any one of claims 1 to 13, **characterized by** comprising steps of:
forming a non-adhesion area on an interposer substrate (10);
mounting said semiconductor chip (1) in such a manner that a top side thereof opposes said interposer substrate (10);
arranging a member(s) that forms gap(s) (4) at side surface(s) of said semiconductor chip (1); and
bending said interposer substrate (10) onto an underside of said member(s).

## Patentansprüche

1. Halbleitergehäuse (5, 5A, 5B; 112A, 112B), **dadurch gekennzeichnet, dass** es umfasst:
einen Halbleiterchip (1) mit einer Mehrzahl Elektroden, die auf einer Schaltungsseitenfläche davon gebildet sind; und
ein Zwischenlagensubstrat (10), das so angeordnet ist, dass es einen Abschnitt der Schaltungsseite des Halbleiterchips (1), einen Abschnitt mindestens einer Seitenfläche davon und einen Abschnitt der Unterseitenfläche davon, die der Schaltungsseitenfläche gegenüberliegt, umschließt, und das eine Verdrahtungsschicht (12) zwischen zwei Isolierschichten (11, 13) aufweist;
wobei ein vorgeschriebener Spalt (4) at der Seitenfläche des Halbleiterchips (1) vorgesehen ist, indem der Halbleiterchip (1) weg von dem Zwischenlagensubstrat (10) beabstandet ist; und
wobei die Unterseitenfläche des Halbleiterchips einen Abschnitt, der an dem Zwischenlagensubstrat (10) haftet, und einen Abschnitt, der nicht an dem Zwischenlagensubstrat (10) haftet, in einem Abschnitt gegenüber der Schaltungsseite aufweist, wobei der angehaftete Abschnitt durch die Isolierschicht (11, 13) selbst an einer der Isolierschichten (11, 13) haftet.

2. Halbleitergehäuse (5, 5A, 5B; 112A, 112B) nach Anspruch 1, **dadurch gekennzeichnet, dass** das Zwischenlagensubstrat (10) ein erstes Elektrodenfeld (14), das zum Verbinden mit einer Elektrode des Halbleiterchips (1) vorgesehen ist, vorgesehen an der Oberfläche des Halbleiterchips (1) an der Seite davon über der Verdrahtungsschicht (12), und ein zweites Elektrodenfeld (15a, 15b), das zur externen Verbindung vorgesehen ist, vorgesehen an der gegenüberliegenden Oberflächenseite des Halbleiterchips (1) gegenüber einer Oberfläche für die Verdrahtungsschicht (12), aufweist.

3. Halbleitergehäuse (5, 5A, 5B; 112A, 112B) nach Anspruch 1 oder 2, **dadurch gekennzeichnet, dass** es weiterhin umfasst:
einen ersten Leiter (2), der eine Elektrode an dem Halbleiterchip (1) mit dem ersten Elektrodenfeld (14) verbindet; und
einen zweiten Leiter (3), der an dem zweiten Elektrodenfeld (15a, 15b) vorgesehen ist.

4. Halbleitergehäuse (5, 5A, 5B; 112A, 112B) nach einem der Ansprüche 1 bis 3, **dadurch gekennzeichnet, dass** sich, wenn das Zwischenlagensubstrat (10) gedrückt wird oder erwärmt und aus einer Richtung der Seitenfläche des Halbleiterchips (1) gedrückt wird, der Spalt (4) mindestens auf die Unterseite des Halbleiterchips (1) zu bewegt und ein Zustand erreicht wird, in dem eine nichthaftende Oberfläche (11a) des Zwischenlagensubstrats (10) sich von der Unterseite des Halbleiterchips (1) löst.

5. Halbleitergehäuse (5, 5A, 5B; 112A, 112B) nach einem der Ansprüche 1 bis 4, **dadurch gekennzeichnet, dass** der Haftbereich zwischen dem Zwischenlagensubstrat (10) und dem Halbleiterchip (1) an der Unterseitenfläche des Halbleiterchips (1) weniger als die Hälfte des Gesamtbereichs der Unterseitenfläche des Halbleiterchips (1) ist.

6. Halbleitergehäuse (5, 5A, 5B; 112A, 112B) nach einem der Ansprüche 1 bis 5, **dadurch gekennzeichnet, dass** das Zwischenlagensubstrat (10) haftend an der Unterseitenfläche des Halbleiterchips (1) an einem Abschnitt davon in der Nähe der Mitte des Halbleiterchips (1) befestigt ist.

7. Halbleitergehäuse (5, 5A, 5B; 112A, 112B) nach einem der Ansprüche 1 bis 6, **dadurch gekennzeichnet, dass** von den beiden Isolierschichten (11, 13) des Zwischenlagensubstrats (10) die Isolierschicht, die auf der Seite des Zwischenlagensubstrats (10) liegt (11), der Oberseite des Halbleiterchips (1) entgegengesetzt, ein thermoplastisches Harz umfasst.

8. Halbleitergehäuse (5, 5A, 5B; 112A, 112B) nach einem der Ansprüche 1 bis 7, **dadurch gekennzeichnet, dass** es weiterhin ein Füllelement (16) umfasst, das aus einem geschmeidigen Material gebildet ist, das in dem Spalt (4) zwischen dem Halbleiterchip (1) und dem Zwischenlagensubstrat (10) an der Seitenfläche des Halbleiterchips (1) vorgesehen ist.

9. Halbleitergehäuse (5, 5A, 5B; 112A, 112B) nach einem der Ansprüche 4 bis 8, **dadurch gekennzeichnet, dass** das Füllelement (16) aus einem Gummimaterial gebildet ist.

10. Halbleitergehäuse (5, 5A, 5B; 112A, 112B) nach einem der Ansprüche 4 bis 9, **dadurch gekennzeichnet, dass** das Füllelement (16) aus einem Material gebildet ist, das bei einer Temperatur, an der Lötmittel schmilzt, oder einer niedrigeren Temperatur weich wird.

11. Halbleitergehäuse (5, 5A, 5B; 112A, 112B) nach einem der Ansprüche 1 bis 10, **dadurch gekennzeichnet, dass** das Zwischenlagensubstrat (10) seinen mittleren Abschnitt an der Schaltungsseitenfläche des Halbleiterchips (1) platziert und beide Endabschnitte davon auf die Unterseite des Halbleiterchips (1) gefaltet und voneinander beabstandet aufweist.

12. Halbleitergehäuse (5, 5A, 5B; 112A, 112B) nach einem der Ansprüche 1 bis 10, **dadurch gekennzeichnet, dass** das Zwischenlagensubstrat (10) seinen mittleren Abschnitt an der Schaltungsseitenfläche des Halbleiterchips (1) platziert und beide Endabschnitte davon auf die Unterseite des Halbleiterchips (1) gefaltet und überlappend aufweist.

13. Halbleitergehäuse (5, 5A, 5B; 112A, 112B) nach einem der Ansprüche 1 bis 10, **dadurch gekennzeichnet, dass** das Zwischenlagensubstrat (10) seinen mittleren Abschnitt an der Schaltungsseitenfläche des Halbleiterchips (1) platziert und beide Endabschnitte davon auf die Schaltungsseite des Halbleiterchips (1) gefaltet und auf der Schaltungsseite des Halbleiterchips (1) voneinander beabstandet aufweist.

14. Verfahren zum Herstellen eines Halbleitergehäuses nach einem der Ansprüche 1 bis 13, **dadurch gekennzeichnet, dass** es die folgenden Schritte umfasst:
Bilden eines nichthaftenden Bereichs an einem Zwischenlagensubstrat (10);
Anbringen des Halbleiterchips (1) auf eine solche Weise, dass eine Oberseite davon dem Zwischenlagensubstrat (10) gegenüberliegt;
Anordnen eines oder mehrerer Elemente, das/die einen/mehrere Spalte (4) an einer oder mehrerer Seitenflächen des Halbleiterchips (1) bildet/bilden; und
Biegen des Zwischenlagensubstrats (10) auf eine Unterseite des Elements/der Elemente.

## Revendications

1. Boîtier semi-conducteur (5, 5A, 5B; 112A, 112B) **caractérisé en ce qu'**il comprend :
une puce semi-conductrice (1) ayant une pluralité d'électrodes formées sur sa surface du côté du circuit ; et
un substrat interposeur (10) agencé afin d'enfermer une partie du côté du circuit de ladite puce semi-conductrice (1), une partie d'au moins sa surface latérale et une partie de sa surface inférieure opposée à ladite surface de côté du circuit et ayant une couche de câblage (12) entre deux couches isolantes (11, 13) ;
un interstice prédéterminé (4) est prévu au niveau de la surface latérale de ladite puce semi-conductrice (1) en éloignant ladite puce semi-conductrice (1) dudit substrat interposeur (10) ; et
ladite surface inférieure de ladite puce semi-conductrice a une partie collée audit substrat interposeur (10), et une partie non collée audit substrat interposeur (10), dans une partie opposée audit côté de circuit, ladite partie collée étant collée à l'une desdites couches isolantes (11, 13) au moyen de la couche isolante (11, 13) elle-même.

2. Boîtier semi-conducteur (5, 5A, 5B; 112A, 112B) selon la revendication 1, **caractérisé en ce que** ledit substrat interposeur (10) a un premier plot électrode (14) qui est prévu pour se raccorder à une électrode de ladite puce semi-conductrice (1), prévue sur la surface de la puce semi-conductrice (1) sur son côté au-dessus de ladite couche de câblage (12), et une second plot électrode (15a, 15b) qui est prévu pour la connexion externe, prévu sur le côté de surface opposé de ladite puce semi-conductrice (1) opposée à une surface pour la couche de câblage (12).

3. Boîtier semi-conducteur (5, 5A, 5B; 112A, 112B) selon la revendication 1 ou 2, **caractérisé en ce qu'**il comprend en outre :
un premier conducteur (2) connectant une électrode sur ladite puce semi-conductrice (1) et ledit premier plot électrode (14) ; et
un second conducteur (3) prévu sur ledit second plot électrode (15a, 15b).

4. Boîtier semi-conducteur (5, 5A, 5B; 112A, 112B) selon l'une quelconque des revendications 1 à 3, **caractérisé en ce que**, lorsque ledit substrat interposeur (10) est poussé, ou chauffé ou poussé depuis une direction de la surface latérale de ladite puce semi-conductrice (1), l'interstice (4) se déplace au moins vers la face inférieure de ladite puce semi-conductrice (1) et on atteint un état dans lequel une surface non collée (11a) dudit substrat interposeur (10) s'éloigne de la face inférieure de ladite puce semi-conductrice (1).

5. Boîtier semi-conducteur (5, 5A, 5B; 112A, 112B) selon l'une quelconque des revendications 1 à 4, **caractérisé en ce que** la surface d'adhésion entre ledit substrat interposeur (10) et ladite puce semi-conductrice (1) sur la surface inférieure de ladite puce semi-conductrice (1) est inférieure à la moitié de la surface totale de la surface inférieure de ladite puce semi-conductrice (1).

6. Boîtier semi-conducteur (5, 5A, 5B; 112A, 112B) selon l'une quelconque des revendications 1 à 5, **caractérisé en ce que** ledit substrat interposeur (10) est fixé de manière adhésive à la surface inférieure de ladite puce semi-conductrice (1) au niveau de sa partie à proximité du centre de ladite puce semi-conductrice (1).

7. Boîtier semi-conducteur (5, 5A, 5B; 112A, 112B) selon l'une quelconque des revendications 1 à 6, **caractérisé en ce que** parmi les deux couches isolantes (11, 13) dudit substrat interposeur (10), la couche isolante située (11) du côté du substrat interposeur (10) opposé au côté supérieur de ladite puce semi-conductrice (1) comprend une résine thermoplastique.

8. Boîtier semi-conducteur (5, 5A, 5B; 112A, 112B) selon l'une quelconque des revendications 1 à 7, **caractérisé en ce qu'**il comprend en outre un élément de remplissage (16) formé avec un matériau pliable prévu dans ledit interstice (4) entre ladite puce semi-conductrice (1) et ledit substrat interposeur (10) sur la surface latérale de ladite puce semi-conductrice (1).

9. Boîtier semi-conducteur (5, 5A, 5B; 112A, 112B) selon l'une quelconque des revendications 4 à 8, **caractérisé en ce que** ledit élément de remplissage (16) est formé avec un matériau en caoutchouc.

10. Boîtier semi-conducteur (5, 5A, 5B; 112A, 112B) selon l'une quelconque des revendications 4 à 9, **caractérisé en ce que** ledit élément de remplissage (16) est formé avec un matériau qui ramollit à une température à laquelle la soudure fond ou inférieure.

11. Boîtier semi-conducteur (5, 5A, 5B; 112A, 112B) selon l'une quelconque des revendications 1 à 10, **caractérisé en ce que** ledit substrat interposeur (10) a sa partie centrale placée sur la surface de côté du circuit de ladite puce semi-conductrice (1) et ses deux parties d'extrémité pliées sur la face inférieure de ladite puce semi-conductrice (1) et éloignées l'une de l'autre.

12. Boîtier semi-conducteur (5, 5A, 5B; 112A, 112B) selon l'une quelconque des revendications 1 à 10, **caractérisé en ce que** ledit substrat interposeur (10) a sa partie centrale placée sur la surface de côté du circuit de ladite puce semi-conductrice (1) et ses deux parties d'extrémité pliées sur la face inférieure de ladite puce semi-conductrice (1) et chevauchées.

13. Boîtier semi-conducteur (5, 5A, 5B; 112A, 112B) selon l'une quelconque des revendications 1 à 10, **caractérisé en ce que** ledit substrat interposeur (10) a sa partie centrale placée sur la surface inférieure de ladite puce semi-conductrice (1) et ses deux parties d'extrémité pliées du côté du circuit de ladite puce semi-conductrice (1) et éloignées l'une de l'autre du côté du circuit de ladite puce semi-conductrice (1).

14. Procédé pour fabriquer un boîtier semi-conducteur selon l'une quelconque des revendications 1 à 13, **caractérisé en ce qu'**il comprend les étapes consistant à :
former une surface sans adhésion sur un substrat interposeur (10) ;
monter ladite puce semi-conductrice (1) de sorte que son côté supérieur s'oppose audit substrat interposeur (10) ;
agencer un (des) élément(s) qui forme(nt) un (des) interstice(s) (4) au niveau de la (des) surface(s) latérale(s) de ladite puce semi-conductrice (1) ; et
courber ledit substrat interposeur (10) sur une face inférieure dudit (desdits) élément(s).
